# EUROPEAN PATENT APPLICATION

(11) **EP 4 755 639 A1**
(43) Date of publication of application: **10.06.2026**
(21) Application number: 25221021.6
(22) Date of filing: 05.12.2025
(51) Int. Cl.: B41J 2/14, B41J 2/16, H10N 30/082

(54) **PIEZOELECTRIC ELEMENT, METHOD FOR MANUFACTURING PIEZOELECTRIC ELEMENT, LIQUID EJECTION HEAD, LIQUID EJECTION APPARATUS**

(30) Priority: 06.12.2024 JP 2024213911
(71) Applicant: Canon Kabushiki Kaisha, Tokyo 146-8501 (JP)
(72) Inventor: MIDORIKAWA, Chihiro, Tokyo 146-8501 (JP); FUKAYA, Youichi, Tokyo 146-8501 (JP)
(74) Representative: TBK

(57) **Abstract**

The present disclosure provides a piezoelectric element (10) including upper and lower electrodes (102, 106) and a piezoelectric layer (104) provided on a base substrate and an insulation layer (108) covering at least the base substrate, the upper and lower electrodes, and the piezoelectric layer. The piezoelectric layer's longitudinal cross section has a tapered shape wider at the lower electrode side than at the upper electrode side. A side surface of the piezoelectric layer has a step surface parallel to the lower electrode, a first side surface from the step surface to the lower electrode, and a second side surface from the step surface to the piezoelectric layer's upper surface. An angle θ₁ between the step surface and the first side surface exceeds 135°. An angle θ₂ between the second side surface and an imaginary plane extended from the step surface and parallel to the lower electrode is 45° or more and less than 75°.

## Description

### TECHNICAL FIELD

The present disclosure relates to a piezoelectric element, a method for manufacturing the piezoelectric element, a liquid ejection head including the piezoelectric element, and a liquid ejection apparatus.

### BACKGROUND

A piezoelectric body, which changes its shape upon application of an electric field, is applied to various industrial products as a means of moving or vibrating an object minutely and accurately. For example, piezoelectric bodies are used in compact speakers, hard disk drives, printers (image-printing liquid ejection apparatuses), and the like. Among them, some printers employ, in their liquid ejection heads, energy generation elements using a piezoelectric body as elements that generate energy for ejecting liquid droplets from the liquid ejection heads. In such a liquid ejection head, a piezoelectric element is formed by a piezoelectric layer and electrodes (an upper electrode and a lower electrode) sandwiching the piezoelectric layer from above and below. Application of an electric field to the electrodes of a piezoelectric element drives the piezoelectric element and causes liquid droplets to be ejected.

A voltage necessary to displace a piezoelectric element sufficiently is several tens of volts. This voltage is a relatively high voltage for a semiconductor device. Thus, a piezoelectric element used in a liquid ejection head is typically covered almost entirely by an insulation layer having a favorable dielectric strength. However, such an insulation layer may separate from the piezoelectric layer at timings such as in a manufacturing process after a step of forming the insulation layer or during the driving of the piezoelectric element. To help prevent such separation, it is effective to mitigate stress concentration at an edge portion of the piezoelectric layer during the driving of the piezoelectric element. To mitigate stress concentration at an edge portion of the piezoelectric layer during the driving of the piezoelectric element, a method for manufacturing a liquid ejection head described in Japanese Patent Laid-Open No. 2010-219153 (Patent Literature 1) provides a step on the lower electrode side of a side surface of the piezoelectric layer of the piezoelectric element. In this way, the step provided at the piezoelectric layer reduces stress exerted to the insulation layer during the driving of the piezoelectric element.

### SUMMARY

In a case where a step is formed at a side surface of a piezoelectric layer, stress may concentrate at an edge portion of the piezoelectric element during the driving of the piezoelectric element, and this may compromise the coverability of the insulation layer covering the piezoelectric layer.

Thus, the present disclosure is directed to provide a piezoelectric element mitigating stress concentration at the edge portion of the piezoelectric element during the driving of the piezoelectric element and also covering a piezoelectric layer with an insulation layer with good coverability.

The present disclosure in its first aspect provides a piezoelectric element as specified in claim 1. Optional features are specified in claims 2 to 8.

The present disclosure in its second aspect provides a method for manufacturing a piezoelectric element as specified in claim 9. Optional features of the method are specified in claims 10 to 12.

The present disclosure can provide a piezoelectric element mitigating stress concentration at the edge portion of a piezoelectric layer during the driving of the piezoelectric element and also covering the piezoelectric layer with the insulation layer with good coverability.

Features of the present disclosure will become apparent from the following description of embodiments with reference to the attached drawings. The following description of embodiments is described by way of example.

### BRIEF DESCRIPTION OF THE DRAWINGS

Figs. 1A and 1B are each a schematic diagram illustrating an example structure of a piezoelectric element of the present disclosure;
Figs. 2A and 2B are schematic diagrams illustrating an example structure of the piezoelectric element of the present disclosure;
Fig. 3 is schematic diagrams showing a method for manufacturing the piezoelectric element of the present disclosure;
Figs. 4A to 4C are schematic diagrams showing a method for manufacturing the piezoelectric element of the present disclosure;
Figs. 5A and 5B are schematic diagrams illustrating an example structure of the piezoelectric element of the present disclosure;
Figs. 6A and 6B are schematic diagrams showing another embodiment of the piezoelectric element of the present disclosure;
Figs. 7A and 7B are diagrammatic illustrations showing a liquid ejection apparatus and a liquid ejection head using the piezoelectric element of the present disclosure; and
Fig. 8 is a schematic diagram showing the main part of a piezoelectric element substrate of the present disclosure.

### DESCRIPTION OF THE EMBODIMENTS

A piezoelectric element having a step formed at a side surface of a piezoelectric layer can mitigate concentration of stress at an edge portion of the piezoelectric layer during the driving of the piezoelectric element and reduce stress exerted to an insulation layer formed on the piezoelectric layer. However, in a case of a piezoelectric element in which the side surface of the piezoelectric layer has an angle close to a right angle, such as 75° or more and 90° or less described in Patent Literature 1, the step may become a factor in lowering the coverability of the insulation layer in a forming process of the insulation layer. As a result of examination, the inventors found that a gap where an insulation layer is absent was sometimes formed near a point of intersection between the side surface of the piezoelectric layer and the upper surface of the step formed at the lower electrode side of the side surface. Such a gap may cause separation of the insulation layer, cracks, or the like.

The present disclosure is directed to a piezoelectric element in which stress concentration at an edge portion of the piezoelectric element during the driving of the piezoelectric element is mitigated and in which an insulation layer covers a piezoelectric layer with good coverability.

Embodiments of a piezoelectric element of the present disclosure are described below with reference to the drawings. The following embodiments are examples of the present disclosure, not intended to limit the scope of the present disclosure to them. The dimensions, shapes, quantities, materials, and the like of elements in the following embodiments can be changed as needed without departing from the scope of the present disclosure, unless otherwise noted.

In the present disclosure, a step portion is provided at a side surface of a piezoelectric element, and a side surface portion closer to the lower electrode with respect to the step portion in the side surface the piezoelectric element has a smaller inclination angle than an inclination angle of a side surface near upper electrode with respect to the step portion. Such a structural feature is to help prevent separation and breakdown of the insulation layer covering the piezoelectric element, particularly its side surface.

In the present disclosure, a direction along a longer side of a piezoelectric element (a longitudinal direction) is defined as an X-axis direction, a direction along a shorter side of the piezoelectric element (a width direction) is defined as a Y-axis direction, and a direction along the thickness of the piezoelectric element (a film thickness direction) is defined as a Z-axis direction. The X-axis direction, the Y-axis direction, and the Z-axis direction are orthogonal to one another. Also, in the present disclosure, the sealing film side of the piezoelectric element is also expressed using terms such as "on," "upper side," "upper part," "upper surface," or "layer above," and a side opposite to the sealing film side (the base substrate side) is also expressed using terms such as "below," "lower side," "lower part," "lower surface," or "layer below." In the drawings for the present disclosure, the X-axis, the Y-axis, and the Z-axis are denoted as arrows, and the directions of the arrows are denoted as "+" directions.

In the present disclosure, a piezoelectric element refers to an element including at least a base substrate having an oxide film layer and the following layers provided on the base substrate: a piezoelectric layer and lower and upper electrodes formed in such a manner as to sandwich the piezoelectric layer. Also, in the present disclosure, an element including not only the base substrate, the piezoelectric layer, and the lower and upper electrodes described above, but also an insulation layer, an upper electrode pad, a lower electrode pad, signal wiring, common wiring, a sealing film, and a part with a recessed portion formed in part of the sealing film is also referred to as a piezoelectric element to simplify the description of the present disclosure. Also, an electrode provided at the lower side (the base substrate side) of the piezoelectric layer is referred to as a lower electrode, and an electrode provided at the upper side (the sealing film side) of the piezoelectric layer is referred to as an upper electrode.

### (A) First Embodiment of the Piezoelectric Element of the Present Disclosure

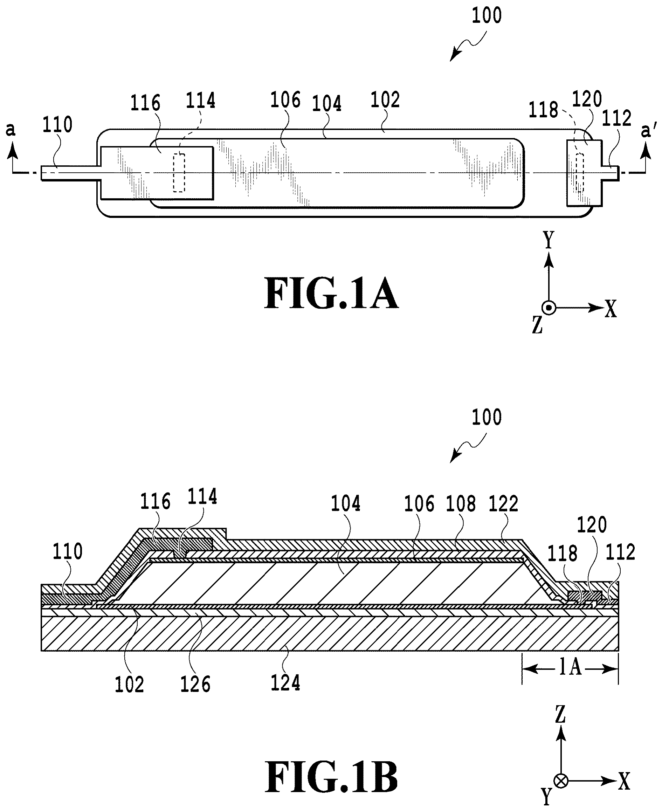

A piezoelectric element of the present disclosure is described with reference to the drawings. The piezoelectric element described below is an example of the present disclosure and is not intended to limit the piezoelectric element of the present disclosure. Also, it should be noted that the drawings used in the following description are schematic, and some parts may be omitted to illustrate the piezoelectric element of the present disclosure. For instance, Fig. 1A omits depiction of the insulation layer and the sealing film.

A first embodiment of the piezoelectric element of the present disclosure is described with reference to Figs. 1A and 1B. Fig. 1A is a top view of a piezoelectric element 100 of the present disclosure. Fig. 1B shows a sectional view taken along the line a-a' in Fig. 1A. The piezoelectric element 100 has a lower electrode 102, a piezoelectric layer 104 formed on the upper surface of the lower electrode 102, and an upper electrode 106 formed on the upper surface of the piezoelectric layer 104. The piezoelectric element 100 also has an insulation layer 108. The insulation layer 108 covers at least the upper surface of the upper electrode 106 and the side surfaces of the piezoelectric layer 104. The insulation layer further covers the upper surface of the lower electrode 102 at a portion where the piezoelectric layer 104 is not formed and the upper surface of the piezoelectric layer 104 at a portion where the upper electrode 106 is not formed. The piezoelectric element 100 is provided with signal wiring 110 for supplying operation signals and common wiring 112 for giving a common potential. An upper electrode contact portion 114 is opened in one of the end portions of the insulation layer in the longitudinal direction (the X-axis direction) of the piezoelectric element 100, and an upper electrode pad 116 is disposed as a layer on the upper electrode contact portion 114. The upper electrode 106 and the upper electrode pad 116 are electrically connected to each other via the upper electrode contact portion 114. The piezoelectric element 100 has the signal wiring 110, and the signal wiring 110 is electrically connected to the upper electrode 106 of the piezoelectric element 100 via the upper electrode pad 116. In the piezoelectric element 100, the lower electrode 102 has an extended region near the other end portion in the longitudinal direction, opposite from the upper electrode pad 116. A lower electrode contact portion 118 is opened in the insulation layer 108 above this extended region, and a lower electrode pad 120 is disposed as a layer on the lower electrode contact portion 118. The lower electrode pad 120 is connected to the lower electrode 102 via the lower electrode contact portion 118, and the common wiring 112 is electrically connected to the lower electrode 102. A sealing film 122 is provided to the piezoelectric element 100, covering the insulation layer 108 as well as the wiring and the electrode pads described above and thus covering the piezoelectric element. The piezoelectric element 100 can include a base substrate 124 at the lower side of the lower electrode side. The base substrate 124 may have an oxide film 126 between the base substrate 124 and the lower electrode.

The following describes each of the elements of the piezoelectric element described above. The piezoelectric element of the present disclosure is characterized by the structure of side surfaces in the longitudinal direction side of the piezoelectric layer 104 (hereinafter also referred to simply as side surfaces of the piezoelectric layer). The following first describes the piezoelectric layer and then describes each of the elements other than the piezoelectric layer.

### (1) Piezoelectric Layer

The piezoelectric layer 104 is provided on the lower electrode. The piezoelectric layer 104 may be selected from materials including lead zirconate titanate, barium titanate, lead titanate, lead metaniobate, bismuth titanate, zinc oxide, aluminum nitride, potassium sodium niobate, or the like. In one embodiment of the present embodiment, lead zirconate titanate can be used for the piezoelectric layer 104 since it makes it easier to achieve a large amount of displacement.

In the piezoelectric element 100, as shown in Fig. 1B, the side surfaces of the piezoelectric layer 104 each have a tapered shape such that the width in the longitudinal direction increases in a direction from the upper electrode side to the lower electrode side (in the -Z-direction, the film thickness direction). In this way, in the piezoelectric element of the present disclosure, a cross section of the piezoelectric layer has a tapered shape wider in the longitudinal direction at the lower electrode side than at the upper electrode side.

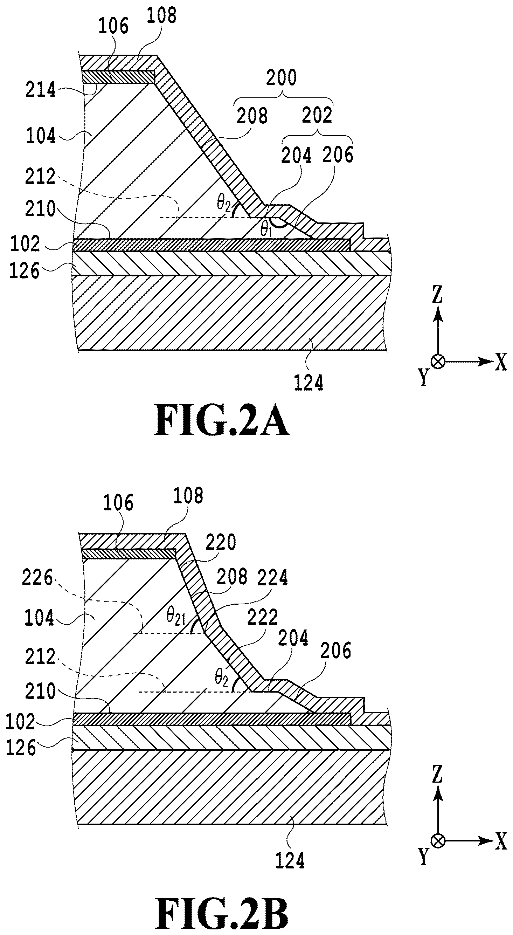

Fig. 2A is an enlarged view of the region 1A in Fig. 1B. Note that Fig. 2B omits the common wiring 112, the lower electrode contact portion 118, the lower electrode pad 120, the sealing film 122, and the like so as not to complicate the diagram. As shown in Fig. 2A, the piezoelectric layer 104 has a side surface portion 200. The piezoelectric element of the present disclosure has a step portion 202 at the lower electrode side of the side surface portion 200 of the piezoelectric layer. The step portion 202 has a step surface 204 parallel to the lower electrode 102 and a first side surface 206 extending from the step surface 204 to the lower electrode 102. The first side surface is a side surface of the piezoelectric layer extending from the step surface 204 to a lower-electrode upper surface 210. In the present disclosure, the angle formed by the step surface 204 and the first side surface 206 is referred to as θ₁. In one embodiment, the angle θ₁ can be more than 135°. In one embodiment of the present disclosure, θ₁ can be 140° or more and 160° or less.

The piezoelectric element 100 of the present disclosure has a second side surface 208 extending from the step surface 204 to the upper electrode 106. The second side surface 208 is a side surface extending from the step surface 204 to a piezoelectric-layer upper surface 214. In the present disclosure, the angle formed by the second side surface 208 of the piezoelectric layer and an imaginary plane 212 parallel to the lower-electrode upper surface 210 (in the present disclosure, also referred to as an imaginary plane extended from the step surface 204 toward the inside of the piezoelectric layer in parallel to the lower electrode) is referred to as θ₂. In one embodiment of the present disclosure, the angle θ₂ can be 45° or more and less than 75°. In one embodiment, the angle θ₂ can be 50° or more and 70° or less.

In the piezoelectric element of the present disclosure, the insulation layer 108 can be thinner than the piezoelectric layer and thin enough not to hinder the displacement of the piezoelectric element. Meanwhile, with the θ₁ and θ₂ falling within the ranges described above, the angle between the first side surface and the lower electrode is smaller than θ₂ , and hence, the insulation layer can maintain favorable coverability at the first side surface. Also, the structure having the step surface 204 can increase the surface area of the step portion 202 (the step surface 204 and the first side surface 206 combined) and therefore increase the area of contact between the step portion 202 and the insulation layer. The structure can prevent separation and breakdown of the insulation layer at the side surface of the piezoelectric layer during the driving of the piezoelectric element.

The side surface portion 200 of the piezoelectric layer 104 of the present disclosure has the step portion 202 at the lower electrode 102 side and distributes stress applied during the driving of the piezoelectric element, mitigating concentration of the stress. For this reason, the piezoelectric element is improved in durability. In a case where the step portion 202 is too thin, a crack may generate at the step portion 202. More specifically, in a case where a thickness from the lower-electrode upper surface 210 to the step surface 204 is too thin, the clack may generate at the step portion 202 as a result of not being able to withstand concentration of stress applied upon displacement of the piezoelectric element. Thus, the thickness from the lower-electrode upper surface 210 to the step surface 204 can be one-tenth or more. In one embodiment, the thickness can be one-tenth or greater and one-third or less of the thickness of the piezoelectric layer 104 measured from the lower-electrode upper surface 210 to the piezoelectric-layer upper surface 214. Exceeding the upper limit of the thickness "one-third or less" is undesirable, since it would decrease the amount of displacement of the piezoelectric element.

The piezoelectric element 100 expands and contracts upon application of high voltage. In a case where there is a gap at the interface between the insulation layer 108 and the piezoelectric layer 104 or in a case where an adhesion between the insulation layer 108 and the piezoelectric layer 104 are insufficient, expansion and contraction of the insulation layer may cause separation of the insulation layer 108 from the piezoelectric layer 104 or breakdown of the insulation layer. With the piezoelectric element 100 of the present disclosure, the angle θ₂ formed between the second side surface 208 and the step surface 204 can be 45° or more and less than 75° and is therefore small compared to a case where the angle is a right angle (90°). This allows the insulation layer to be formed with a uniform density on the upper surface of the step surface 204 and the upper surface of the second side surface 208 and thus makes it less likely for a gap to be formed. Thus, the piezoelectric element of the present disclosure is less prone to separation of the insulation layer from the piezoelectric layer or breakdown of the insulation layer. Also, not only does the piezoelectric element of the present disclosure have the step portion 202 at the side surface portion 200 of the piezoelectric layer, but also the angle θ₁ formed between the step surface 204 and the first side surface 206 exceeds 135°. Thus, the area of contact between the piezoelectric layer 104 and the insulation layer 108 is large, making it possible to achieve favorable adhesion between the insulation layer 108 and the piezoelectric layer 104. From this perspective as well, separation of the insulation layer 108 from the piezoelectric layer 104 and breakdown of the insulation layer are less likely to occur.

As shown in Fig. 2B, the second side surface 208 may be formed by two inclination surfaces: an inclination surface 220 and an inclination surface 222. However, it is desirable that an angle θ₂₁ formed between the inclination surface 220 and a plane 226 extending from a connection point 224 between the inclination surfaces 220 and 222 in parallel to the lower-electrode upper surface 210 is 90° or less. This is because θ₂₁ exceeding 90° makes it more likely for a gap portion absent of the insulation layer 108 to be generated at the second side surface 208.

Although the above-described example in Fig. 2B shows a case where the second side surface has two inclination surfaces, the second side surface 208 in the present disclosure may have two or more inclination surfaces. In that case, there is not particularly limitation on the number of inclination surfaces, but the number of inclination surfaces can be n + 1, where n can be an integer of 1 or more, and in one embodiment, n may be 1 or more and 8 or less. Also, in a case where there are a plurality of inclination surfaces, the angle formed between each of the plurality of inclination surfaces and a plane parallel to the lower electrode 102 can be smaller than a corresponding angle for an immediately previous inclination surface of the inclination surfaces. Also, in a case where there are a plurality of inclination surfaces, each of the angles corresponding to the above-described angle θ₂₁ can be 90° or less. Also, the above-described angle between each adjacent pair of the plurality of inclination surfaces can has a similar relation to the relation of the angle θ₂₁ and the angle θ₂.

Although one of the end portions of the piezoelectric element is shown as an example in the above description, the piezoelectric element of the present disclosure has the side surface portion 200 configured in the same way as described above at both of the end portions of the piezoelectric layer in the longitudinal direction.

### (2) Base Substrate

The base substrate 124 may be a film of a material selected from silicon nitride, silicon, metal, heat-resistant glass, and the like according to the necessary mechanical properties, reliability, and the like. In the present embodiment, in a case where a silicon wafer is used for the base substrate 124, the base substrate 124 has the silicon oxide film (an oxide film) 126 as an insulation layer on a surface side where the lower electrode 102 is formed.

### (3) Lower Electrode

The lower electrode 102 is provided on the base substrate. The lower electrode 102 may be exposed to high temperatures of several hundred degrees Celsius in a process performed after the lower electrode 102 is formed. In such a case, a material with a high melting point can be used as the material for the lower electrode. The material includes copper, platinum, gold, chrome, cobalt, titanium, and their alloys. Also, in a case where the piezoelectric layer 104 is formed in contact with the upper surface of the lower electrode 102, the lower electrode 102 may function also as a film for controlling the crystal orientation of the piezoelectric layer. In this case, a material with an appropriate crystal structure is selected as needed for the lower electrode. In the present embodiment, in a case where lead zirconate titanate is used as the material for the piezoelectric layer 104, platinum can be used as the lower electrode 102 serving as a crystal orientation controlling film.

### (4) Upper Electrode

The upper electrode 106 is provided on the piezoelectric layer. The upper electrode 106 may be conductive, and a material typically used as an electrode material can be used as the material for the upper electrode 106. Examples of a usable material include aluminum, copper, tungsten, titanium, chrome, gold, platinum, and their alloys. Note that in a case where a material with large internal stress is used for the lower electrode 102, the piezoelectric layer 104 may bend. In such a case, the upper electrode 106 may be given opposite internal stress to cancel out the overall stress on the entire piezoelectric element. Examples of such a material include alloys of titanium or tungsten.

### (5) Insulation Layer

The insulation layer 108 is provided on the upper electrode. Examples of the material for the insulation layer 108 include typical insulation materials such as silica, silicon nitride, oxynitride, and alumina. Further, the insulation layer 108 may be a multilayered film formed by two or more materials selected from the materials described above. Note that high voltage of 30 V or more is typically applied in order to drive the piezoelectric element 100. Thus, a material and a film thickness for the insulation layer 108 are selected considering the dielectric breakdown strength. In a case where the insulation layer 108 is too thin, leakage occurs due to the dielectric strength of the insulation layer 108 being inadequate. Conversely, in a case where the insulation layer 108 is too thick, it would hinder the displacement of the piezoelectric element, decreasing the amount of displacement. Thus, it is possible that the thickness of the insulation layer 108 be one-tenth or more and one-fourth or less of the thickness of the piezoelectric layer 104.

### (6) Signal Wiring and Common Wiring

Any material typically used for electric wiring can be used for the signal wiring 110 and the common wiring 112, and the material is not particularly limited. Examples include aluminum, copper, gold, and their alloys. Also, a titanium or chrome film may be interposed to improve the adhesion of the signal wiring and the common wiring to the layer therebelow. Note that the piezoelectric element 100 is typically driven by application of high voltage of 30 V or more at high frequency in the range of several hundred to several thousand hertz. Thus, the wiring can be formed to have a high slew rate by having a relatively thick film thickness or the like.

### (7) Sealing Film

The sealing film 122 covers the entire piezoelectric element including the signal wiring 110 and the common wiring 112 as well as the upper electrode pad 116 and the lower electrode pad 120. It is possible that the material used for the sealing film 122 has high insulation and coverage properties. For example, silica, silicon nitride, alumina, and the like with high insulation properties are favorable as the material for the sealing film. The provision of the sealing film can prevent current from flowing at the surface of the piezoelectric element under a humid environment and thus prevent breakage.

The piezoelectric element 100 of the present disclosure described above can reduce occurrence of separation or cracking of the insulation layer.

### (B) Method for Manufacturing the Piezoelectric Element of the First Embodiment of the Present Disclosure

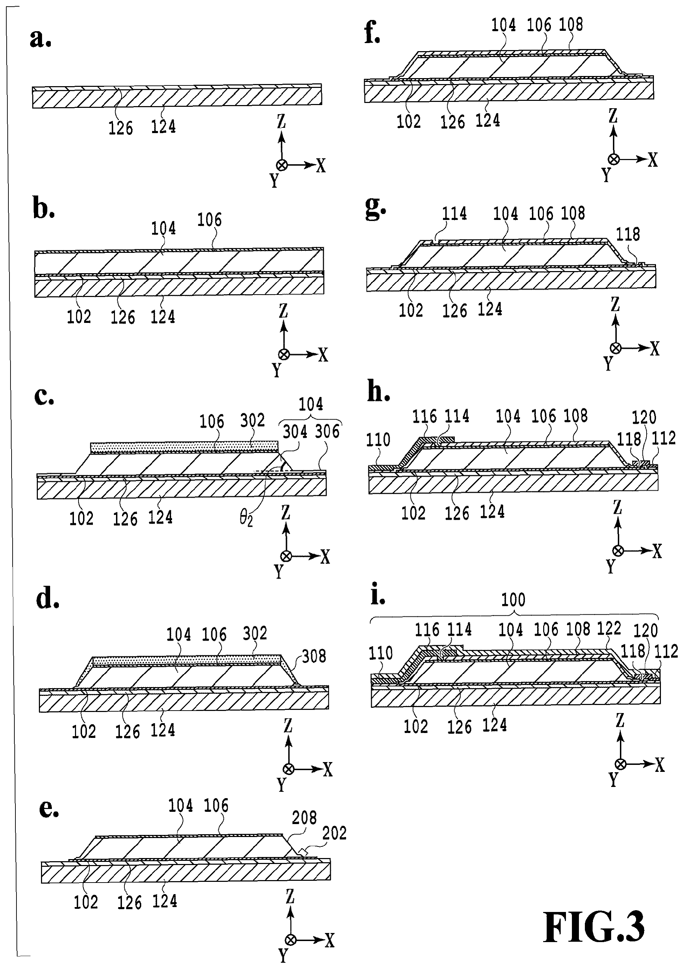

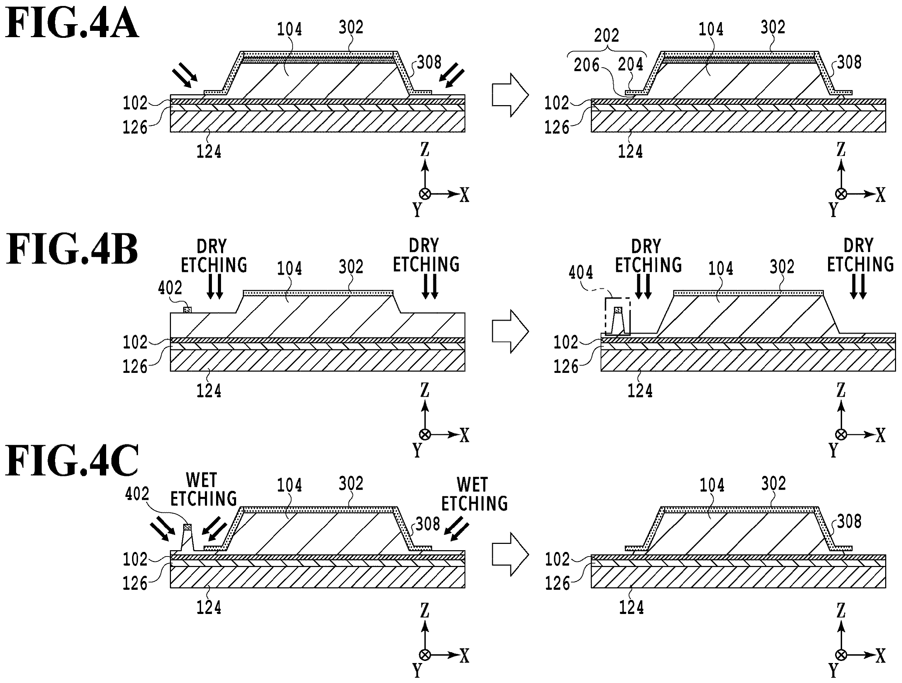

With reference to Fig. 3 and Figs. 4A to 4C, a method for manufacturing the piezoelectric element of the first embodiment described above is described below.

As shown in Fig. 3a., the base substrate 124 is provided. The silicon thermal oxide film 126 (which is herein referred to as the oxide film 126) with a thickness of approximately 500 nm is formed on the upper surface (a first surface) of the base substrate 124 using the wet oxidation process. The wet oxidation process is a method for forming a silicon thermal oxidation film using oxygen and nitrogen gas.

Next, as shown in Fig. 3b., the lower electrode 102, the piezoelectric layer 104, and the upper electrode 106 are formed in this order on the oxide film 126 formed on the base substrate 124. The materials described earlier can be used for the lower electrode 102. Sputtering, vapor deposition, or other methods may be used to form the lower electrode. For example, a 110-nm-thick platinum film can be formed using sputtering. With sputtering, for example, a film can be formed using Ar gas with the pressure being in the range of 0.2 Pa or higher and 1.2 Pa or lower and the DC power being in the range of 300 W or more and 800 W or less. Note that to achieve stronger adhesion between the lower electrode 102 and the oxide film 126, for example, a titanium film with a film thickness of approximately 15 nm can be formed as an adhesion layer (not shown).

Next, the piezoelectric layer is formed on the lower electrode 102 using, for example, a liquid phase method (the sol-gel method), sputtering, or the like. In a case of forming the piezoelectric layer 104 using a liquid phase method (the sol-gel method), first, a sol-gel solution is applied to a substrate using spin coating and is dried under a temperature of 200 °C or higher and 300 °C or lower. Next, the dried substrate is baked at 700 °C in an O₂ atmosphere to crystallize the piezoelectric body. As a result of repeating this step, a piezoelectric layer with a desired film thickness can be formed. For example, in a case of forming a layer of lead zirconate titanate, the piezoelectric layer 104 can be formed by repeating formation of a layer of lead zirconate titanate using the sol-gel method a plurality of times to achieve (100) orientation. As the upper electrode 106, a film of a titanium-tungsten alloy can be formed on the piezoelectric layer 104 using sputtering, vapor deposition, or the like. The conditions for forming the upper electrode using sputtering may be the same as those for forming the lower electrode.

Next, as shown in Fig. 3c., a mask 302 is formed using photolithography in order for the upper electrode 106 and the piezoelectric layer 104 to be in a desired pattern. Dry etching is performed on the upper electrode 106 with the mask, thereby patterning the upper electrode 106. Next, a portion of the piezoelectric layer 104 exposed from the mask 302 is reduced in film thickness by dry etching. Note that for example, processing conditions for the dry etching may be as follows: BCl₃ for the etching gas, 0.3 Pa for the pressure, 400 W for the antenna RF, 150 W for the bias RF, and 500 seconds for the processing time. Alternative processing conditions for the dry etching may be, for example, C₄F₈ for the etching gas and 2000 seconds for the etching time. After the processing, the piezoelectric layer has a piezoelectric-layer raised portion 304 whose upper surface is covered by the mask 302 and a thin film portion 306. The side surface of the raised portion 304 corresponds to the second side surface 208 in Fig. 2A. Also, the thin film portion 306 corresponds to the step surface 204 in Fig. 2A. The angle θ₂ formed by the second side surface 208 and a plane along the step surface of the thin film portion 306 formed as described above (a plane parallel to the lower electrode) can be 45° or more and less than 75°.

The thickness of the thin film portion 306 corresponds to the thickness of the step portion 202. The thickness of the thin film portion 306, i.e., a thickness from the upper surface of the lower electrode 102 to the step surface 204 can be controlled by the processing time of the dry etching for thinning. Such control can be performed as needed by those skilled in the art. For example, the thickness of the thin film portion 306 may be approximately 300 nm.

Next, as shown in Fig. 3d., a mask 308 is formed using photolithography on the raised portion 304 and a portion of the thin film portion 306 surrounding the raised portion 304. The thin film portion 306 is patterned by wet etching. For example, Pure Etch PT204 manufactured by Hayashi Pure Chemical Ind., Ltd. can be used as the etchant. Specifically, wet etching can be performed using a mixed liquid of NaF and HCl as the etchant. The processing time is changed as needed depending on the mixing ratio and concentrations of NaF and HCl, a method for forming the piezoelectric layer, and the thickness of the step portion. For example, the processing time may be approximately five seconds in order to form the 300-nm-thick step portion by etching using PT204, which is a mixed liquid of NaF (1%) and HCl (10%). As a result, the step portion 202 made of a piezoelectric body is formed around the piezoelectric-layer raised portion 304 on the lower electrode 102 side. A portion of the thin film portion 306 covered by the mask 308 corresponds to the step surface 204 in Fig. 2B. In this manufacturing method, with wet etching, the etching may reach a portion exposed from the mask 308 and a portion inward (in the horizontal direction of the piezoelectric layer, the longitudinal direction of the piezoelectric layer, or the -X-direction in Fig. 3) of the border portion of the mask and remove the piezoelectric layer below the border portion of the mask (immediately below the mask) as well. A side surface (an inclination surface) of the piezoelectric layer thus formed by the wet etching corresponds to the first side surface 206 (Fig. 4A).

Typically, in forming an inclination surface, wet etching can achieve a smaller taper angle than dry etching. Thus, the shape of the step portion 202 can be formed in this step with good reproducibility (Fig. 4A).

Also, because platinum, which is favorably used as the lower electrode 102, and lead zirconate titanate, which is favorably used as the piezoelectric layer, are both materials that are hard to etch, it is difficult to set a high selectivity ratio in dry etching. Thus, with dry etching, the lower electrode 102 is excessively etched (over-etched), leading to degradation of electrical characteristics. By contrast, with wet etching, compared to dry etching, a higher selectivity ratio can be set between the material for the piezoelectric layer and the material for the lower electrode, and it is possible to minimize an etching of the lower electrode 102 due to excessive etching (over-etching).

The angle θ₁ formed between the first side surface 206 and the step surface 204 thus formed can be more than 135°. In one embodiment, the angle θ₁ can be 140° or more and 160° or less.

Also, as shown in Fig. 4B, in a case where dry etching is performed on the piezoelectric layer, a by-product of the etching may attach to a region to be etched and become a mask 402, generating an undesired etching residue 404. By using wet etching to pattern the portion exposed from the mask 308 as in this embodiment, such an undesired etching residue can be removed simultaneously (Fig. 4C). This is an advantage of the manufacturing method in the present disclosure. Also, with wet etching, unlike dry etching, etching progresses horizontally (the longitudinal direction of the piezoelectric layer or the -X-direction) as well as described above, and as shown in Fig. 4C, a peripheral portion of the piezoelectric layer, i.e., a portion immediately below an edge portion of the mask 308, may be removed as well.

Next, as shown in Fig. 3e., a resist pattern (not shown) is formed again using photolithography so that the lower electrode 102 would be in a desired pattern, and then the lower electrode 102 is patterned by etching.

Next, as shown in Fig. 3f., the insulation layer 108 is formed on the entire surface of the base substrate 124 having a pattern formed thereon. Although not specifically shown, in the present embodiment, the insulation layer 108 may be a multilayer body having a multilayer structure. In a case where the insulation layer 108 has a multilayer structure, the insulation layer 108 is formed by the following procedure: first forming a film of, for example, aluminum oxide using atomic layer deposition (ALD) and then forming a silicon oxide film using chemical vapor deposition (CVD). Note that the insulation layer 108 may be formed by a combination of ALD and CVD or only by CVD.

Next, as shown in Fig. 3g., through holes are formed in the insulation layer 108 using photolithography, one penetrating to the upper electrode 106 and the other penetrating to the lower electrode 102. These through holes correspond to the upper electrode contact portion 114 and the lower electrode contact portion 118. These through holes may be formed by formation of a resist pattern (not shown) on the lower electrode and then execution of etching.

Next, as shown in Fig. 3h., a wiring material is formed on the insulation layer 108 by sputtering or the like. A material such as an aluminum-copper alloy may be used as the wiring material. A resist pattern (not shown) having a desired pattern is formed using photolithography on the insulation layer including the formed wiring material, and etching is performed to form the signal wiring 110 and the common wiring 112 and further the upper electrode pad 116 and the lower electrode pad 120.

Next, as shown in Fig. 3i., the sealing film 122 is formed to cover the insulation layer, the wiring, and the electrode pads. For example, the sealing film can be formed by using CVD as a 250-nm-thick film of silicon nitride, which is high in resistance to moisture. After this, although not shown, an opening is formed in the sealing film 122 at a portion above an electrode terminal through resist patterning and etching. Through this opening, each of the signal wiring 110 and the common wiring 112 is connected to a circuit or device configured to drive an actuator located at the end of the wiring. A voltage is applied from this circuit or device to drive the piezoelectric element of the present disclosure.

A High Temperature High Humidity Bias Test is conducted on the piezoelectric element 100 thus produced in order to evaluate its durability. Specifically, for 200 hours, the piezoelectric element is kept in an environment with a temperature of 85 °C and a humidity of 85% with a DC voltage of 60 V being applied thereto. After that, the state of the piezoelectric element 100 is checked.

### (C) Second Embodiment of the Piezoelectric Element of the Present Disclosure

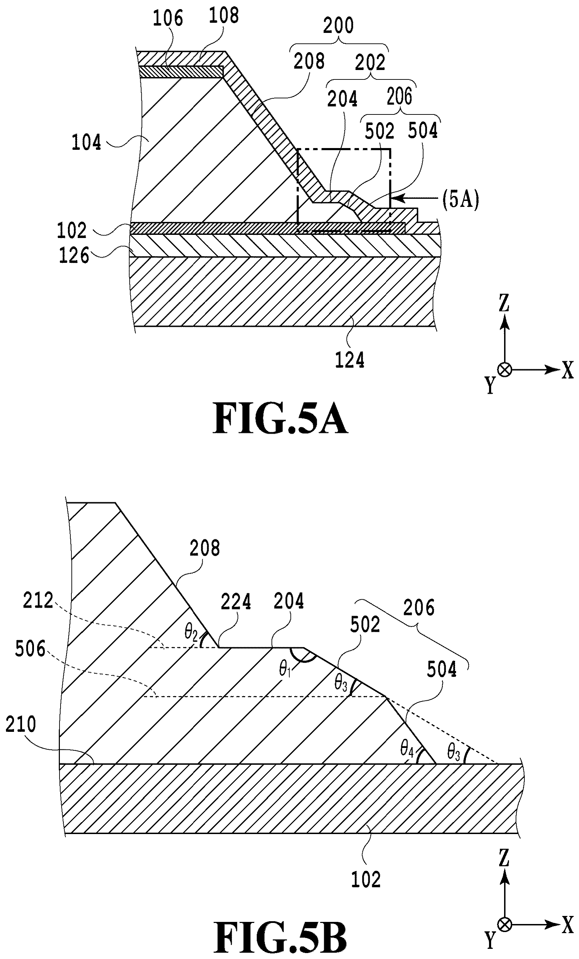

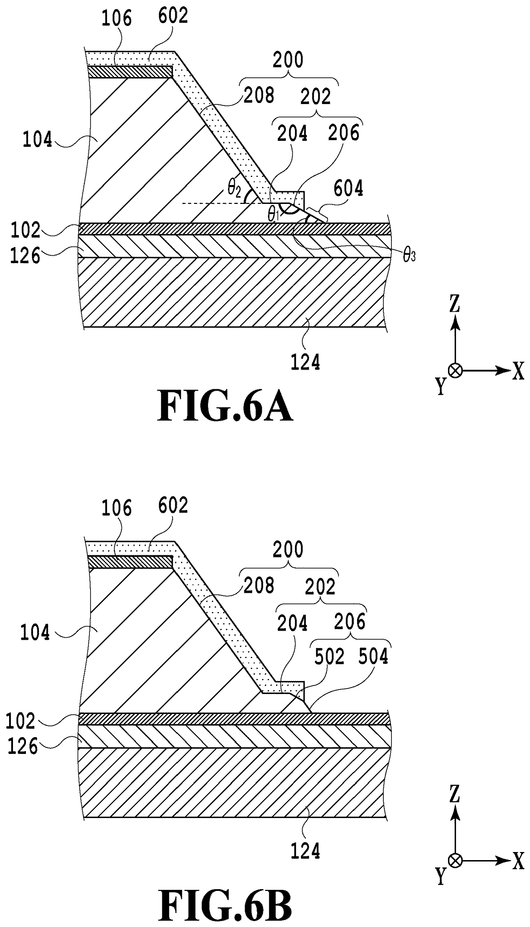

A second embodiment of the piezoelectric element of the present disclosure is described with reference to Figs. 5A, 5B, 6A, and 6B.

The piezoelectric element of the second embodiment has a plurality of inclination surfaces at the first side surface 206 described in the first embodiment. The following describes the second embodiment in specific terms, taking an example where the first side surface 206 has a first inclination surface 502 and a second inclination surface 504 as shown in Figs. 5A and 5B. The following description provides an example to illustrate the second embodiment of the present disclosure, and there is no intension of limiting the piezoelectric element of the present disclosure.

Figs. 5A and 5B each show a partial sectional view of a side surface portion of the piezoelectric element 100 of the present embodiment. With reference to Fig. 5A, the configuration of the second embodiment is described. In the piezoelectric element of the second embodiment, like that of the first embodiment of the present disclosure, the piezoelectric layer 104 has a tapered shape such that its longitudinal width increases in a direction from the upper electrode side to the lower electrode side (the -Z-direction or the film thickness direction). The piezoelectric element of the second embodiment has the step portion 202 formed at the lower electrode side of the side surface portion 200 of the piezoelectric layer 104. The step portion 202 has the step surface 204 parallel to the lower electrode 102 and the first side surface 206 extending from the step surface 204 to the lower electrode 102. The first side surface is a side surface of the piezoelectric layer extending from the step surface 204 to the lower-electrode upper surface 210. In the present embodiment, the angle formed between the step surface 204 and the first side surface 206 is referred to as θ₁. The angle θ₁ can be more than 135°. In one embodiment of the present disclosure, θ₁ may be 140° or more and 160° or less.

Fig. 5B shows a sectional view of an area near an edge portion of the side surface portion of the piezoelectric layer 104 of the present embodiment (the portion denoted by (5A) in Fig. 5A) (note that Fig. 5B does not depict the upper electrode 106 and the insulation layer 108 for simplicity). The first side surface 206 has the first inclination surface 502 in direct contact with the step surface 204 and the second inclination surface 504 extending from the first inclination surface 502 to the lower electrode 102. The angle θ₁ formed between the step surface 204 and the first inclination surface 502 is the same as the angle θ₁ described above and can be more than 135°. In one embodiment, the angle θ₁ may be 140° or more and 160° or less. In the piezoelectric element 100 of the present embodiment, the first side surface 206 has the first inclination surface 502 and the second inclination surface 504. An angle θ₄ formed between the lower electrode 102 and the second inclination surface 504 can be 90° or less.

As described above, in the piezoelectric element 100 of the present embodiment, the first side surface 206 has the first inclination surface 502 and the second inclination surface 504. Thus, the first side surface can have a larger surface area in the piezoelectric element 100 of the present embodiment than that of the piezoelectric element of the first embodiment described above. Also, in a case where the angle θ₄ formed between the lower electrode 102 and the second inclination surface 504 is greater than an angle θ₃ formed between the first inclination surface 502 and a plane 506 parallel to the lower-electrode upper surface 210, the area of contact between the piezoelectric layer 104 and the lower electrode 102 is small. Thus, the area of the bottom surface of the piezoelectric layer (the base area) can be reduced in the piezoelectric element 100.

Note that the angle formed between the first inclination surface 502 and the plane 506 parallel to the lower-electrode upper surface 210 is defined as θ₃ herein. The angle θ₃ can also be defined as an angle formed between the lower-electrode upper surface 210 and a plane imaginarily extended from the first inclination surface 502 as shown in the sectional view in Fig. 5B.

### (D) Method for Manufacturing the Piezoelectric Element of the Second Embodiment of the Present Disclosure

A method for preparing the piezoelectric element 100 of the second embodiment is described below.

The piezoelectric element of the present embodiment is similar to that of the first embodiment except for the step of processing the first side surface 206. Thus, the step of processing the first side surface 206 is described below. Other processing steps are as described in the first embodiment.

A step of preparing the first side surface of the present embodiment is described with reference to Figs. 6A and 6B. Figs. 6A and 6B are schematic diagrams of a step of processing the first side surface of the piezoelectric layer 104 in the present embodiment.

As shown in Fig. 6A, using photolithography, a mask 602 is formed so as to expose part of the first side surface 206 on an edge portion side 604 of the piezoelectric element. Next, the edge portion side 604 of the piezoelectric layer 104, which is exposed from the mask 602, is dry-etched. This method for processing the first side surface in the present embodiment is the same as the processing method for forming the first side surface in the first embodiment. Conditions for the processing of the first side surface can be as follows: 0.3 Pa for the pressure, 400 W for the antenna RF, 150 W for the bias RF, and 50 seconds for the processing time. As a result, as shown in Fig. 6B, the first inclination surface 502, which is on the step surface 204 side, and the second inclination surface 504, which is an inclination surface extending from a lower part of the first inclination surface 502 to the lower electrode 102, are formed at the first side surface 206. The angle formed by the second inclination surface 504 thus formed and the lower electrode 102 is defined as θ₄ (Fig. 5B). The angle θ₄ can be greater than the angle θ₃ shown in Fig. 5B.

A High Temperature High Humidity Bias Test is conducted on the piezoelectric element 100 thus produced in order to evaluate its durability. Specifically, for 200 hours, the piezoelectric element is kept in an environment with a temperature of 85 °C and a humidity of 85% with a DC voltage of 60 V being applied thereto. After that, the state of the piezoelectric element 100 is checked.

The above description of the second embodiment demonstrates an example where the first side surface 206 is formed by two inclination surfaces: the first inclination surface 502 and the second inclination surface 504. However, in the present disclosure, the first side surface 206 may be formed by two or more inclination surfaces. In that case, there is no particular limitation on the number of inclination surfaces.

In the present disclosure, in a case where the first side surface 206 includes a plurality of inclination surfaces, an inclination surface extending from the step surface 204 to the lower electrode 102 can have a first inclination surface to an (n + 1)-th inclination surface, where n can be an integer of 1 or more, and in one embodiment, may be an integer of 1 or more and 5 or less. Also, the angle formed between each of the plurality of inclination surfaces and the lower electrode 102 or a plane parallel to the lower electrode 102 can be greater than a corresponding angle for the immediately previous one of the inclination surfaces.

According to the piezoelectric element of the present disclosure described above, occurrence of separation and cracking of the insulation layer can be reduced. Further, for a piezoelectric element, it is desirable to prevent adverse effects on, e.g., the amount of displacement of the piezoelectric element during the driving of the piezoelectric element. The piezoelectric element of the present disclosure can reduce such an adverse effect.

### (E) Third Embodiment

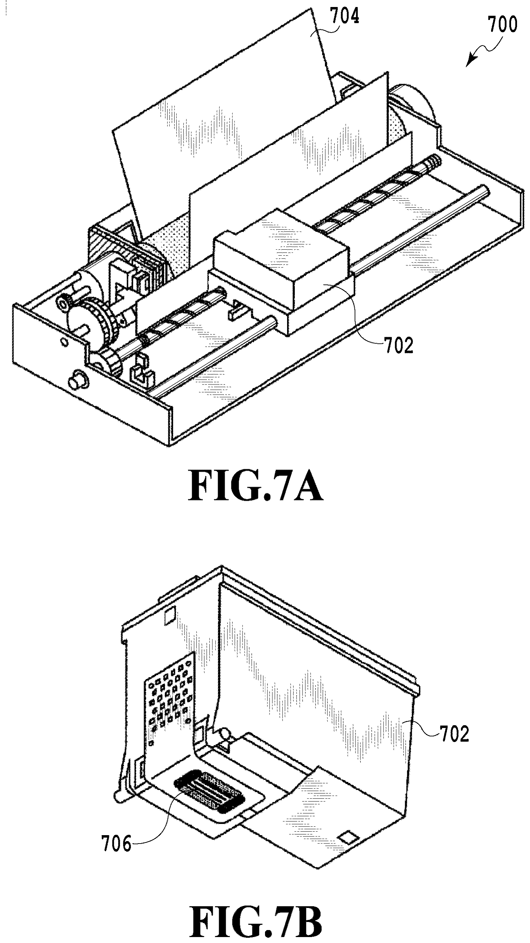

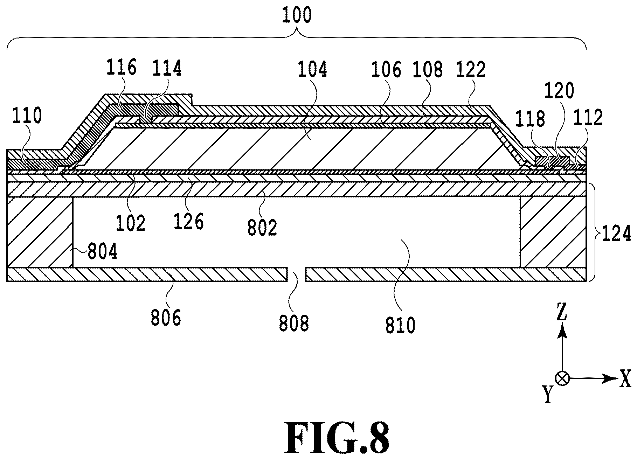

An inkjet printer as a liquid ejection apparatus to which the piezoelectric element of the present disclosure can be applied is described with reference to Figs. 7A, 7B, and 8.

Figs. 7A and 7B are each an overall diagram showing the configuration of the main part of an inkjet printer as the liquid ejection apparatus to which the piezoelectric element of the present disclosure can be applied. Fig. 7A is an overall view showing an overall configuration of a liquid ejection apparatus 700. As shown in Fig. 7A, the liquid ejection apparatus 700 includes a liquid ejection head 702, a carriage movable in the direction in which the liquid ejection head 702 scans, and a conveyance mechanism configured to convey a medium 704. The liquid ejection apparatus 700 can cause ink to land on a desired position on the medium 704 by causing the carriage carrying the liquid ejection head 702 and movable in the scan direction to move in accordance with conveyance of the medium 704. In this way, the liquid ejection apparatus 700 prints an image on the medium 704 by ejecting ink droplets from ejection ports (not shown) corresponding to nozzles of the liquid ejection head 702. Although a serial-type liquid ejection apparatus is shown as an example in the present embodiment, the piezoelectric element of the present disclosure can be applied to a full-line-type liquid ejection apparatus as well.

Fig. 7B is a perspective view showing the liquid ejection head 702, which is a constituent of the liquid ejection apparatus 700. As shown in Fig. 7B, the liquid ejection head 702 includes a piezoelectric element substrate 706 having a plurality of nozzle arrays each being an array of a plurality of nozzles.

Fig. 8 is a diagram showing the configuration of the main part of the piezoelectric element substrate 706 of the liquid ejection head 702 of the present embodiment. The piezoelectric element substrate 706 has the piezoelectric elements 100 of any of the embodiments described above. The base substrate 124 described in the above embodiments has the oxide film 126 formed thereon and has a vibrating plate 802, a flow path forming substrate 804, and a nozzle plate 806, the nozzle plate 806 having a nozzle hole 808 formed therein. A plurality of nozzle holes 808 may be formed. A liquid ink is ejected from the nozzle hole 808. The flow path forming substrate 804 is provided on the nozzle plate 806, and the flow path forming substrate 804 defines a space between the nozzle plate 806 and the vibrating plate 802 to form a pressure chamber 810. Although not shown in Fig. 8 for simplicity, various flow paths for ink to flow are formed in the flow path forming substrate 804 in addition to the pressure chamber 810. The ink is supplied to the ink flow paths via a tube from an ink tank provided outside of the liquid ejection head 702 and inside of the liquid ejection apparatus 700. The piezoelectric element 100 is electrically connected to the drive circuit (not shown) and operates based on signals from the drive circuit. The vibrating plate 802 deforms due to the action of the piezoelectric layer 104 and changes the internal pressure in the pressure chamber 810, thereby ejecting ink from the nozzle hole 808.

### Examples

The piezoelectric element of the present disclosure is further described specifically by way of following examples.

### (Example 1)

The present example is an example of the piezoelectric element of the first embodiment.

As shown in Fig. 3a., a silicon wafer was provided as the base substrate 124, and as the oxide film 126, an approximately 500-nm-thick silicon thermal oxide film was formed on the upper surface (a first surface) of the base substrate 124 through a wet oxidation process using oxygen and hydrogen gas.

Next, as shown in Fig. 3b., the lower electrode 102, the piezoelectric layer 104, and the upper electrode 106 were formed in this order on the upper surface of the base substrate 124 having the oxide film 126 formed thereon. As the lower electrode 102, a 110-nm-thick platinum film was formed by sputtering. Also, to achieve stronger adhesion between the lower electrode 102 and the oxide film 126, a 15-nm-thick titanium film was formed as an adhesion layer (not shown). A lead zirconate titanate film having

(100) orientation was formed repeatedly a plurality of times on the lower electrode 102 using a liquid phase method (the sol-gel process), thereby forming a 2.1-µm-thick piezoelectric layer 104. As the upper electrode 106, a 110-nm-thick film of a titanium-tungsten alloy was formed on the piezoelectric layer 104 by sputtering.

Next, as shown in Fig. 3c., the mask 302 was formed using photolithography so that the upper electrode 106 and the piezoelectric layer 104 would be in a desired patten, and then the upper electrode 106 was dry-etched and patterned. Next, a portion of the piezoelectric layer 104 exposed from the mask 302 was dry-etched and reduced in thickness. Processing conditions for the dry etching were as follows: BCl₃ for the etching gas, 0.3 Pa for the pressure, 400 W for the antenna RF, 150 W for the bias RF, and 500 seconds for the processing time. The raised portion 304 having its upper surface covered by the mask 302 and being formed of the piezoelectric layer and the thin film portion 306 were formed at the piezoelectric element as a result of the processing. The side surface of the raised portion 304 corresponds to the second side surface 208 in Fig. 2A. The angle θ₂ formed by the thus-formed thin film portion 306 and the second side surface 208 was 70°.

The thickness of the thin film portion 306 corresponds to the thickness of the step portion 202. A thickness measured from the upper surface of the lower electrode 102 to the step surface 204 can be controlled by the processing time for the dry etching for thinning. In the present example, the thickness of the thin film portion 306 was 300 nm.

Next, as shown in Fig. 3d., the mask 308 was formed using photolithography on the raised portion 304 and a portion of the thin film portion 306 surrounding the raised portion 304. The thin film portion 306 was patterned using wet etching. Pure Etch PT204 manufactured by Hayashi Pure Chemical Ind., Ltd. was used as the etchant. Specifically, an etching process was carried out for approximately five seconds using PT204, which is a mixed liquid of NaF (1%) and HCl (10%), to form a 300-nm-thick step portion. As a result, the step portion 202 formed of a piezoelectric body was formed around the lower electrode 102 side of the raised portion 304 of the piezoelectric layer. A portion of the thin film portion 306 covered by the mask 308 corresponds to the step surface 204 in Fig. 2A, and an inclination surface formed at a portion exposed from the mask 308 corresponds to the first side surface 206.

Typically, in forming an inclination surface, wet etching can achieve a smaller taper angle than dry etching. Thus, the shape of the step portion 202 of the present example can be formed with good reproducibility.

The angle θ₁ formed between the first side surface 206 and the step surface 204 formed in the present example was 150°.

Next, as shown in Fig. 3e., a resist pattern (not shown) was formed using photolithography again so that lower electrode 102 would be in a desired pattern, and then, the lower electrode 102 was patterned by etching.

Next, as shown in Fig. 3f., the insulation layer 108 was formed on the entire patterned surface of the base substrate 124. Note that although not specifically shown, the insulation layer 108 in the present example had a multilayer structure. The insulation layer 108 was formed by the following procedure: first forming a 20-nm-thick aluminum oxide film using atomic layer deposition (ALD) and then forming a 450-um-thick silicon oxide film using chemical vapor deposition (CVD). Note that the insulation layer 108 may be formed by a combination of ALD and CVD or only by CVD.

Next, as shown in Fig. 3g., through holes were formed in the insulation layer 108 using photolithography, one penetrating to the upper electrode 106 and the other penetrating to the lower electrode 102. These through holes can be formed by formation of a resist pattern (not shown) and etching, consequently forming the upper electrode contact portion 114 and lower electrode contact portion 118.

Next, as shown in Fig. 3h., a film of a wiring material was formed on the insulation layer 108 using sputtering. An aluminum-copper alloy was used as the wiring material, and the thickness was set to 700 nm. A resist pattern (not shown) was formed in a desired pattern using photolithography. Next, the signal wiring 110 and the common wiring 112 and further the upper electrode pad 116 and the lower electrode pad 120 were formed using etching.

Next, as shown in Fig. 3i., the sealing film 122 was formed, covering the wiring and the electrode pads. The sealing film was formed by using CVD as a 250-nm-thick film of silicon nitride, which is high in resistance to moisture. After this, although not shown, an opening was formed in the sealing film 122 at a portion above an electrode terminal through resist patterning and etching. Through this opening, each of the signal wiring 110 and the common wiring 112 is connected to a circuit or device configured to drive an actuator located at the end of the wiring. A voltage is applied from this circuit or device.

A High Temperature High Humidity Bias Test was conducted on the obtained piezoelectric element 100 in order to evaluate its durability. Specifically, for 200 hours, the piezoelectric element was kept in an environment with a temperature of 85 °C and a humidity of 85% with a DC voltage of 60 V being applied thereto. As a result of checking the state of the piezoelectric element 100 after that, no breakdown or separation of the insulation layer 108 was observed at the piezoelectric element 100, and the piezoelectric element 100 was confirmed to be in a normal state.

### (Example 2)

Example 2 is an example of the piezoelectric element of the second embodiment of the present disclosure.

The piezoelectric element 100 of Example 2 can be produced by the same method as Example 1 except that the first side surface 206 is processed into a plurality of inclination surfaces. Thus, steps other than the step of processing the first side surface 206 are omitted.

Figs. 6A and 6B each show the step of processing the side wall of the piezoelectric layer 104 in Example 2. As shown in Fig. 6A, using photolithography, the mask 602 was formed so as to expose part of the first side surface 206 which is on the edge portion side 604 of the piezoelectric element. Next, the edge portion side 604 of the piezoelectric layer 104, which is exposed from the mask 602, was dry-etched. Processing conditions for the dry etching in Example 2 were as follows: 0.3 Pa for the pressure, 400 W for the antenna RF, 150 W for the bias RF, and 50 seconds for the processing time. As a result, as shown in Fig. 6B, the first inclination surface 502, which was on the step surface 204 side, and the second inclination surface 504, which was an inclination surface from a lower part of the first inclination surface 502 to the lower electrode 102, were formed at the first side surface 206. The angle θ₄ formed by the second inclination surface 504 thus formed and the lower electrode 102 was 70°.

A High Temperature High Humidity Bias Test was conducted on the obtained piezoelectric element 100 in order to evaluate its durability. Specifically, for 200 hours, the piezoelectric element was kept in an environment with a temperature of 85 °C and a humidity of 85% with a DC voltage of 60 V being applied thereto. As a result of checking the state of the piezoelectric element 100 after that, no breakdown or separation of the insulation layer 108 was observed at the piezoelectric element 100, and the piezoelectric element 100 was confirmed to be in a normal state.

### (Comparative Example 1)

Comparative Example 1 is an example where the angles θ₁ and θ₂ are both outside of the ranges defined in the present disclosure.

A piezoelectric element of the present comparative example was produced with θ₁ being 110°, θ₂ being 80°, the thickness of the piezoelectric layer being 2.1 µm, the thickness of the insulation layer being 450 nm, and the thickness from the surface of the lower electrode to the step surface being 300 nm. The production was done following the same procedure as Example 1.

The durability of the obtained piezoelectric element was evaluated with the same procedure as Example 1. The durability evaluation was performed using a High Temperature High Humidity Bias Test. Specifically, for 200 hours, the piezoelectric element was kept in an environment with a temperature of 85 °C and a humidity of 85% with a DC voltage of 60 V being applied thereto. After that, the state of the piezoelectric element was checked. As a result, the insulation layer was cracked and separated at the edge portion of the piezoelectric element, and current leakage between the lower electrode and the upper electrode attributable to the crack and separation was observed. The crack was present particularly near an intersection point between the second side surface and the step surface. This is believed to be because of a gap formed due to the absence of the insulation layer near the intersection point.

### (Comparative Example 2)

Comparative Example 2 is an example where only the angle θ₁ is outside of the range defined in the present disclosure.

A piezoelectric element of the present comparative example was produced with θ₁ being 110°, θ₂ being 70°, the thickness of the piezoelectric layer being 2.1 µm, the thickness of the insulation layer being 450 nm, and the thickness from the surface of the lower electrode to the step surface being 300 nm. The production was done following the same procedure as Example 1.

The durability of the obtained piezoelectric element was evaluated with the same procedure as Example 1. The durability evaluation was done using a High Temperature High Humidity Bias Test. Specifically, for 200 hours, the piezoelectric element was kept in an environment with a temperature of 85 °C and a humidity of 85% with a DC voltage of 60 V being applied thereto. After that, the state of the piezoelectric element was checked. As a result, the insulation layer was cracked and separated at the end portion of the piezoelectric element, and current leakage between the lower electrode and the upper electrode attributable to the crack and separation was observed. The crack was present particularly near an intersection point between the first side surface and the step surface. It is conceivable that the crack was generated because displacement of the piezoelectric element during the driving caused concentration of stress near the intersection point, leading to separation at the interface between the insulation layer and the first side surface.

### (Comparative Example 3)

Comparative Example 3 is an example where only the angle θ₂ is outside of (greater than) the range defined in the present disclosure.

A piezoelectric element of the present comparative example was produced with the angle θ₁ being 150°, θ₂ being 80°, the thickness of the piezoelectric layer being 2.1 µm, the thickness of the insulation layer being 450 nm, and the thickness from the surface of the lower electrode to the step surface being 300 nm. The production was done following the same procedure as Example 1.

The durability of the obtained piezoelectric element was evaluated with the same procedure as Example 1. The durability evaluation was done using a High Temperature High Humidity Bias Test. Specifically, for 200 hours, the piezoelectric element was kept in an environment with a temperature of 85 °C and a humidity of 85% with a DC voltage of 60 V being applied thereto. After that, the state of the piezoelectric element was checked. As a result, separation was found at the insulation layer at the edge portion of the piezoelectric element, and current leakage between the lower electrode and the upper electrode attributable to the crack and separation was observed. The above-described separation of the insulator occurred particularly near an intersection point between the first side surface and the step surface. It is conceivable that the separation occurred because the insulation layer was absent near the intersection point, forming a gap.

### (Comparative Example 4)

Comparative Example 4 is an example where only the angle θ₂ is outside of (smaller than) the range defined in the present disclosure.

A piezoelectric element of the present comparative example was produced with the angle θ₁ being 150°, θ₂ being 30°, the thickness of the piezoelectric layer being 2.1 µm, the thickness of the insulation layer being 450 nm, and the thickness from the surface of the lower electrode to the step surface being 300 nm. The production was done following the same procedure as Example 1.

The durability of the obtained piezoelectric element was evaluated with the same procedure as Example 1. The durability evaluation was done using a High Temperature High Humidity Bias Test. Specifically, for 200 hours, the piezoelectric element was kept in an environment with a temperature of 85 °C and a humidity of 85% with a DC voltage of 60 V being applied thereto. After that, the state of the piezoelectric element was checked. As a result, breakdown or separation of the insulation layer was not observed at the piezoelectric element, and the piezoelectric element was confirmed to be in a normal state. However, in a case where θ₂ is less than 45°, compared to a case where θ₂ is 45° or more, the amount of displacement of the piezoelectric element during the driving decreased by 5% or more. There is also a disadvantage that the area of the lower part of the piezoelectric element is large relative to the area of the lower electrode.

As thus described, the piezoelectric element of the present disclosure can mitigate concentration of stress at the edge portion of the piezoelectric layer without affecting the amount of displacement of the piezoelectric element, and also the insulation layer covers the piezoelectric element with good coverability.

Various embodiments have been described in detail above but it will be understood that the present disclosure is not limited to these embodiments and encompasses all modifications, variants, alternatives and equivalents falling within the scope of the appended claims.

## Claims

1. A piezoelectric element (100) comprising a lower electrode (102), a piezoelectric layer (104) and an upper electrode (106) on a base substrate, and an insulation layer (108) covering at least the base substrate (124), the lower electrode, the piezoelectric layer, and the upper electrode, wherein
a cross section of the piezoelectric layer in a longitudinal direction of the piezoelectric layer has a tapered shape wider at a side of the lower electrode than at a side of the upper electrode,
a side surface in a longitudinal direction of the piezoelectric layer, which extends from the upper electrode to the lower electrode, has a step surface (204) parallel to the lower electrode, a first side surface (206) extending from the step surface to the lower electrode, and a second side surface (208) extending from the step surface to an upper surface of the piezoelectric layer,
an angle θ₁ formed between the step surface and the first side surface is 135° or more, and
an angle θ₂ formed between the second side surface and an imaginary plane (212) extended from the step surface toward an inside of the piezoelectric layer and parallel to the lower electrode is 45° or more and less than 75°.

2. The piezoelectric element according to claim 1, wherein
the insulation layer is a laminated body having two or more insulation layers.

3. The piezoelectric element according to claim 1 or claim 2, wherein
a thickness of the insulation layer is one-tenth or more and one-fourth or less of a thickness of the piezoelectric layer.

4. The piezoelectric element according to any one of claims 1 to 3, wherein
a thickness from the lower electrode to the step surface is one-tenth or more of a thickness of the piezoelectric layer.

5. The piezoelectric element according to any one of claims 1 to 4, wherein
the first side surface of the piezoelectric layer has two or more inclination surfaces.

6. The piezoelectric element according to any one of claims 1 to 5, wherein
the second side surface of the piezoelectric layer has two or more inclination surfaces.

7. A liquid ejection head comprising the piezoelectric element according to any one of claims 1 to 6.

8. A liquid ejection apparatus comprising the liquid ejection head according to claim 7.

9. A method for manufacturing a piezoelectric element including a lower electrode, a piezoelectric layer and an upper electrode on a base substrate, and an insulation layer covering at least the base substrate, the lower electrode, the piezoelectric layer, and the upper electrode, the method comprising the steps of:
(i) forming the lower electrode on the base substrate;
(ii) forming the piezoelectric layer on the lower electrode;
(iii) forming the upper electrode on the piezoelectric layer;
(iv) forming a first mask on part of the upper electrode and patterning the upper electrode by dry-etching a portion of the upper electrode exposed from the first mask to form a portion where the piezoelectric layer is exposed;
(v) dry-etching the portion where the piezoelectric layer is exposed to thinning a part of the piezoelectric layer and form a tapered shape at a longitudinal side surface of the piezoelectric layer, the tapered shape widening from the upper electrode toward the lower electrode;
(vi) forming a second mask at least on the longitudinal side surface of the piezoelectric layer and a portion surrounding the longitudinal side surface of the piezoelectric layer;
(vii) removing, by wet-etching, a portion exposed from the second mask and surrounding the longitudinal side surface of the piezoelectric layer and a portion immediately below an edge portion of the second mask, thereby forming a step surface at the side surface of the piezoelectric layer on a side closer to the lower electrode; and
(viii) forming the insulation layer covering at least the upper electrode, the side surface and the step surface of the piezoelectric layer, and the lower electrode.

10. The method for manufacturing a piezoelectric element according to claim 9, wherein
by the steps (iv) to (vii), the step surface parallel to the lower electrode, a first side surface extending from the step surface to the lower electrode, and a second side surface extending from the step surface to an upper surface of the piezoelectric layer are formed at the longitudinal side surface of the piezoelectric layer, the longitudinal side surface extending from the upper electrode to the lower electrode,
an angle θ₁ formed between the step surface and the first side surface is more than 135°, and
an angle θ₂ formed between the second side surface and an imaginary plane extended from the step surface toward an inside of the piezoelectric layer and parallel to the lower electrode is 45° or more and less than 75°.

11. The method for manufacturing a piezoelectric element according to claim 9 or claim 10, further comprising, after the step (vii):
(vii') forming a third mask on a portion of the piezoelectric layer extending from the upper electrode to the step surface, the step surface, and part of a first side surface of the piezoelectric layer extending from the step surface to the lower electrode and
(vii") removing part of the first side surface of the piezoelectric layer by dry-etching a portion of the first side surface of the piezoelectric layer exposed from the third mask.

12. The method for manufacturing a piezoelectric element according to claim 11, further comprising, following the step (vii"), repeating the steps (vii') and (vii") a plurality of times.
